# DEMANDE DE BREVET EUROPEEN

(11) **EP 1 557 878 A2**
(43) Date de publication de la demande: **27.07.2005**
(21) Numéro de dépôt: 05290060.2
(22) Date de dépôt: 10.01.2005
(51) Int. Cl.: H01L 21/68, H01L 21/00, B65D 81/20

(54) **Station de contrôle et de purge de mini-environnement**

(30) Priorité: 20.01.2004 FR 0450101
(71) Demandeur: ALCATEL, 75008 Paris (FR)
(72) Inventeur: Bernard, Roland, 74540 Viuz-la-Chiesaz (FR); Kambara, Hisanori, 74350 Villy-le-Pelloux (FR); Favre, Arnaud, 74000 Annecy (FR)
(74) Mandataire: Fournier, Michel Robert Marie

(57) **Abrégé**

Dans un dispositif selon l'invention, une enceinte de mini-environnement (1) de type SMIF peut être raccordée sur une station de purge (2). La station de purge comprend un compartiment étanche de purge (2b) dont la face supérieure comporte un passage de transfert obturable (2c) en regard de la face inférieure (1b) de l'enceinte de mini-environnement (1). Un ascenseur (4) peut déplacer verticalement la paroi inférieure (1b) de l'enceinte de mini-environnement (1) accouplée, déplaçant également une pile de tranches de substrat (3) portée par la paroi inférieure (1c) pour introduire l'ensemble dans le compartiment étanche de purge (2b). La purge de la pile de tranches de substrat (3) est alors réalisée à l'intérieur du compartiment étanche de purge (2b) de la station de purge (2), et la purge de l'enceinte de mini-environnement (1) est simultanément réalisée. On assure ainsi une purge beaucoup plus efficace et rapide, favorisant l'utilisation des enceintes de mini-environnement SMIF dans les procédés de microélectronique.

## Description

La présente invention concerne les dispositifs et procédés pour la réduction de la contamination des tranches de substrat semi-conducteur lors de la fabrication des semi-conducteurs en salle blanche.

L'invention concerne plus spécialement les dispositifs et procédés dans lesquels les enceintes de mini-environnement, ou boîtes d'isolement modulaires, sont utilisées pour stocker et transporter les tranches de substrat semi-conducteur entre les diverses étapes des procédés de fabrication de semi-conducteurs et de microsystèmes électromécaniques (MEMS).

La fabrication des semi-conducteurs et des microsystèmes électromécaniques est habituellement réalisée dans des salles blanches contenant une atmosphère contrôlée à très faible taux de contamination. Toutefois, la réalisation d'une intégration de plus en plus poussée des circuits à semi-conducteurs nécessite la réalisation de circuits élémentaires ayant des géométries de plus en plus petites. De manière typique, les circuits intégrés industriellement réalisés à ce jour comportent ainsi des géométries dont la taille est de l'ordre de 0,13 micromètre. Or les taux de contamination volatile présents dans les salles blanches interfèrent sensiblement avec les géométries de 0,13 micromètre de tels circuits intégrés. Il devient donc déjà nécessaire, en cours de fabrication, de maintenir les tranches de substrat semi-conducteur dans des atmosphères dépourvues de contamination volatile, ou contenant une contamination volatile en des quantités infinitésimales, et cette tendance va se poursuivre à l'avenir avec les besoins croissants d'intégration.

Or il est difficile et onéreux de maintenir un taux de contamination volatile infinitésimal dans une atmosphère de grand volume telle que l'atmosphère d'une salle blanche.

Pour résoudre la difficulté liée à la présence d'une contamination encore excessive dans les salles blanches, et pour éviter les coûts correspondants, on a déjà proposé de placer les tranches de substrat semi-conducteur ou les masques dans des enceintes de mini-environnement pour les protéger des pollutions résiduelles encore présentes dans une salle blanche. C'est ainsi que les documents US 4,532,970 et US 4,534,389 décrivent des enceintes à interface standardisées (SMIF) permettant de transporter des piles de tranches de substrat semi-conducteur de 200 mm de diamètre. L'enceinte à interface standardisée comprend une paroi périphérique étanche munie d'un passage d'accès inférieur obturable pour l'introduction et le retrait d'une pile de tranches de substrat semi-conducteur. La pile de tranches de substrat semi-conducteur est solidaire de la paroi inférieure, l'ensemble étant déplacé lors de l'introduction et du retrait.

Actuellement, les piles de tranches de 300 mm de diamètre sont également transportées dans des enceintes de mini-environnement à ouverture frontale standardisée (FOUP).

Certaines fois, on utilise également des enceintes de mini-environnement adaptées pour le transport d'une seule tranche de substrat.

Les tranches de substrat semi-conducteur ou autres substrats restent typiquement pendant plusieurs semaines dans l'unité de fabrication de semi-conducteurs, entre les diverses étapes des procédés. Au cours de cette durée, les tranches de substrat semi-conducteur sont transportées dans les enceintes de mini-environnement.

Dans les procédés de fabrication de semi-conducteurs, de circuits intégrés, et de microsystèmes électromécaniques, il existe de nombreuses sources de contamination des substrats, et cela représente la cause principale de perte de rendement dans la fabrication de composants. On considère qu'il y a généralement deux types de contaminations : les contaminations par particules, et les contaminations moléculaires.

Une particule est une agglomération stable ou quasi stable de molécules avec des dimensions pouvant descendre jusqu'à quelques nanomètres. Une particule aérosol est une particule suspendue dans l'air ou le gaz ambiant avec une vitesse de déplacement inférieure à toute vitesse arbitraire. Un contaminant moléculaire est un contaminant qui n'est pas classifié comme une particule ou un agglomérat de particules, et il peut s'agir d'une molécule unique, d'une petite collection de molécules, ou d'un film. Il y a en plus des gaz corrosifs qui sont présents dans le mini-environnement, provenant de la chambre de procédés pendant le transfert des substrats ou pendant le dégazage de certains composants ou des réactions chimiques dans l'enceinte de mini-environnement. La présence d'humidité favorise la contamination organique qui affecte la qualité de la couche d'oxyde et réalise un dopage indésirable. La plupart des contaminations se produisent entre les étapes des procédés, pendant que les substrats attendent l'étape suivante.

Pour réduire la présence des sources de contamination dans l'enceinte de mini-environnement, on a déjà imaginé de purger l'atmosphère intérieure de l'enceinte de mini-environnement, comme décrit dans le document US 5,988,233. Pour cela, l'enceinte de mini-environnement est équipée d'une entrée et d'une sortie de gaz, et l'on introduit un gaz non corrosif pour remplacer le gaz corrosif tel que l'air présent dans l'enceinte. L'azote est généralement utilisé comme gaz de purge pour neutraliser l'enceinte de mini-environnement.

Toutefois, on constate que la purge de l'enceinte de mini-environnement est généralement insuffisante, et des sources de pollution non négligeables restent dans l'enceinte de mini-environnement et continuent à produire une baisse de rendement de la fabrication des semi-conducteurs, circuits intégrés et autres composants.

On constate également que la purge de l'enceinte de mini-environnement est une opération relativement longue, qui monopolise pendant une durée non négligeable les moyens de génération de gaz de purge, ce qui réduit le rendement global de l'installation. Habituellement, la purge d'une enceinte de mini-environnement par un tel procédé nécessite une durée de plusieurs dizaines de minutes, et le résultat n'est pas encore suffisant.

En outre, les purges actuellement connues ne s'opèrent pas sur des mini-environnements standards.

Il s'avère particulièrement difficile d'assurer la purge complète d'une enceinte de mini-environnement, et notamment la purge des interstices entre des tranches de substrat empilées les unes au-dessus des autres dans l'enceinte de mini-environnement.

En effet, les inventeurs ont mené une étude, notamment par simulation, et ils ont pu constater que, dans le cas d'une pile de tranches de substrat superposées et séparées les unes des autres par un intervalle, les gaz de purge ne se répartissent pas correctement sur toute la surface des tranches de substrat, et produisent des zones de surface active qui ne sont pas efficacement purgées et sur lesquelles peuvent stagner des contaminations volatiles.

Le problème proposé par la présente invention est d'éviter les inconvénients des systèmes de l'art antérieur, en particulier en permettant de réduire encore de façon sensible les sources de pollution présentes dans une enceinte de mini-environnement, afin de réduire les risques de contamination des tranches de substrat placées dans les enceintes de mini-environnement au cours des procédés de fabrication de composants microélectroniques ou de microsystèmes électromécaniques. On cherche en particulier à réduire les contaminations volatiles.

L'invention vise pour cela à améliorer sensiblement les conditions de purge, afin d'éviter l'apparition de zones mortes dans lesquelles la purge est insuffisante.

L'invention vise également à accélérer sensiblement la purge, afin de limiter le temps nécessaire au cours duquel l'installation de purge est dédiée à la purge d'une enceinte de mini-environnement.

L'invention vise simultanément à améliorer les conditions de purge sans pour autant augmenter le flux de gaz de purge, afin d'éviter les circulations gazeuses violentes qui sont elles-mêmes source de contamination et de dégradation des surfaces des substrats à traiter.

Et l'invention vise à assurer une purge satisfaisante tout en conservant la structure connue des mini-environnements standards.

L'idée qui est à la base de l'invention est de réaliser la purge lorsque l'enceinte de mini-environnement est à l'état ouvert, la pile de tranches de substrats étant située hors de l'enceinte de mini-environnement mais dans une atmosphère contrôlée.

Ainsi, pour atteindre ces buts ainsi que d'autres, l'invention propose un dispositif pour le contrôle et la réduction de contamination d'une pile de tranches de substrats disjointes placée dans une enceinte de mini-environnement, comprenant ladite enceinte de mini-environnement ayant une paroi périphérique étanche munie d'un passage d'accès obturable pour l'introduction et le retrait de la pile de tranches de substrats, caractérisé en ce que ledit dispositif comprend en outre une station de purge en combinaison avec ladite enceinte, ladite station de purge comprenant :
- un compartiment étanche de purge dimensionné pour recevoir et contenir la pile de tranches de substrat disjointes,
- un passage de transfert obturable et des moyens pour l'accouplement sélectif étanche du passage d'accès obturable de l'enceinte de mini-environnement sur le passage de transfert obturable,
- des moyens de manipulateur pour le déplacement de la pile de tranches de substrat entre l'enceinte de mini-environnement et le compartiment étanche de purge,
- des moyens diffuseurs adaptés pour diffuser latéralement un gaz de purge en direction des chants des tranches de substrat de la pile de tranches de substrat parallèlement à leur face principale,
- des moyens collecteurs, disposés pour recueillir le flux diffusé de gaz de purge à l'opposé des moyens diffuseurs après passage entre les tranches de substrat de la pile de tranches de substrat.

On comprendra que l'intérieur de l'enceinte de mini-environnement est purgé par pénétration et sortie des gaz par le passage d'accès obturable qui est alors à l'état ouvert, et, simultanément, la purge des interstices entre les tranches de substrat est assurée dans le compartiment étanche de purge de la station de purge par des moyens qui assurent une diffusion et une répartition particulièrement efficaces du gaz de purge.

Selon un mode de réalisation avantageux, les moyens diffuseurs comprennent une ou plusieurs colonnes de répartition ayant une fente longitudinale continue de largeur appropriée, par exemple de largeur égale à 1 mm environ, pour le passage radial du gaz de purge.

En alternative, les moyens diffuseurs peuvent comprendre une ou plusieurs colonnes de répartition ayant une série de trous répartis le long d'une génératrice de la colonne de répartition.

Selon une autre possibilité avantageuse, les moyens diffuseurs peuvent comprendre une grille verticale rectangulaire placée latéralement en regard de la pile de tranches de substrat.

Avec un tel dispositif, on peut estimer qu'une purge de qualité satisfaisante est obtenue au bout d'une durée de purge d'environ 5 minutes.

De préférence, le compartiment étanche de purge comprend un volume de réserve inférieur occupant l'espace au-dessous de la pile de tranches de substrat disjointes pendant la purge. On réalise ainsi une purge plus homogène et plus rapide, la durée nécessaire étant ramenée à moins de 2 minutes.

Selon un mode de réalisation avantageux, l'invention s'applique aux enceintes de mini-environnement de type enceintes à interface mécanique standardisée (SMIF). Dans ce cas, la paroi de base ferme le passage d'accès obturable et est déplaçable verticalement en supportant la pile de tranches de substrat disjointes. Dans ce cas, la station de purge comporte une face supérieure munie du passage de transfert obturable et munie des moyens d'accouplement étanches pour l'accouplement autour du passage d'accès en autorisant le déplacement vertical de la paroi de base de l'enceinte de mini-environnement jusqu'à l'intérieur du compartiment étanche de purge. Les moyens de manipulateur comprennent un ascenseur logé dans le compartiment étanche de purge et adapté pour supporter la paroi de base de l'enceinte de mini-environnement et la pile de tranches de substrat disjointes et pour les déplacer entre l'enceinte de mini-environnement et le compartiment étanche de purge.

De préférence, la station de purge comprend en outre un dispositif de traitement de gaz de purge, connecté à l'espace intérieur du compartiment étanche de purge pour recueillir les gaz de purge.

De bons résultats sont obtenus en prévoyant que le dispositif de traitement de gaz de purge est connecté :
- au dispositif collecteur, pour recevoir les gaz de purge après leur passage entre les tranches de substrat de la pile de tranches de substrat disjointes,
- au volume de réserve inférieur, pour recevoir les gaz confinés dans le volume de réserve inférieur,
- à la zone supérieure du compartiment étanche de purge, au voisinage du passage de transfert obturable.

Il est utile d'aspirer les gaz de purge hors du compartiment étanche de purge pour les évacuer par une canalisation d'évacuation.

Pour cela, une première solution consiste à prévoir des moyens de pompage spécifiques qui aspirent les gaz de purge hors du compartiment étanche de purge et qui les refoulent dans la canalisation d'évacuation.

Mais il est préférable d'utiliser, comme moyens d'aspiration, les moyens d'aspiration prévus sur la salle blanche elle-même dans laquelle est placé le dispositif de l'invention.

Dans ce cas, selon un premier mode de réalisation, ladite canalisation d'évacuation est raccordée à la canalisation d'aspiration de la salle blanche.

Selon un mode de réalisation préféré, la canalisation d'évacuation se déverse de façon non étanche à l'entrée d'un collecteur de sortie, ladite entrée étant elle-même largement ouverte sur la salle blanche et la sortie du collecteur de sortie étant connectée à la canalisation d'aspiration de la salle blanche. On évite ainsi de mettre en dépression le volume de purge, ce qui nuirait à la paroi en plastique de l'enceinte de mini-environnement. Cela permet dans le même temps de purger l'enceinte de mini-environnement elle-même.

Un contrôle de l'atmosphère intérieure, et de la qualité de purge, est obtenu en prévoyant des moyens d'analyse des gaz pompés.

Par exemple, les moyens d'analyse des gaz pompés peuvent comprendre des moyens d'analyse de gaz et des capteurs d'humidité.

De préférence, compte tenu du type de contamination volatile à éliminer, les moyens d'analyse des gaz pompés peuvent comprendre un spectromètre à mobilité ionique (IMS).

D'autres objets, caractéristiques et avantages de la présente invention ressortiront de la description suivante de modes de réalisation particuliers, faite en relation avec les figures jointes, parmi lesquelles :
- la figure 1 illustre schématiquement une enceinte de mini-environnement accouplée à une station de purge selon un mode de réalisation de la présente invention ;
- la figure 2 est une vue en perspective illustrant la structure générale du système à station de purge selon la figure 1 ;
- la figure 3 illustre les moyens de pompage et de traitement associés à une station de purge des figures 1 ou 2, selon un mode de réalisation à moyens de pompage spécifiques ;
- la figure 4 illustre un autre mode de réalisation dans lequel le dispositif de l'invention utilise l'aspiration générale de la salle blanche pour évacuer les gaz de purge ;
- la figure 5 illustre un mode de réalisation préféré dans lequel le dispositif de l'invention utilise l'aspiration générale de la salle blanche en évitant la mise en dépression du volume de purge ;
- la figure 6 illustre les moyens de répartition selon un premier mode de réalisation à colonne de répartition ;
- la figure 7 illustre les moyens de répartition selon un second mode de réalisation à colonne de répartition ;
- la figure 8 illustre les moyens de répartition selon un troisième mode de réalisation à grille de répartition ; et
- la figure 9 illustre l'évolution de la concentration d'un mélange d'air et d'azote lors de l'utilisation d'une diffusion latérale d'azote pour purger de l'air par l'azote dans une station de purge selon l'invention.

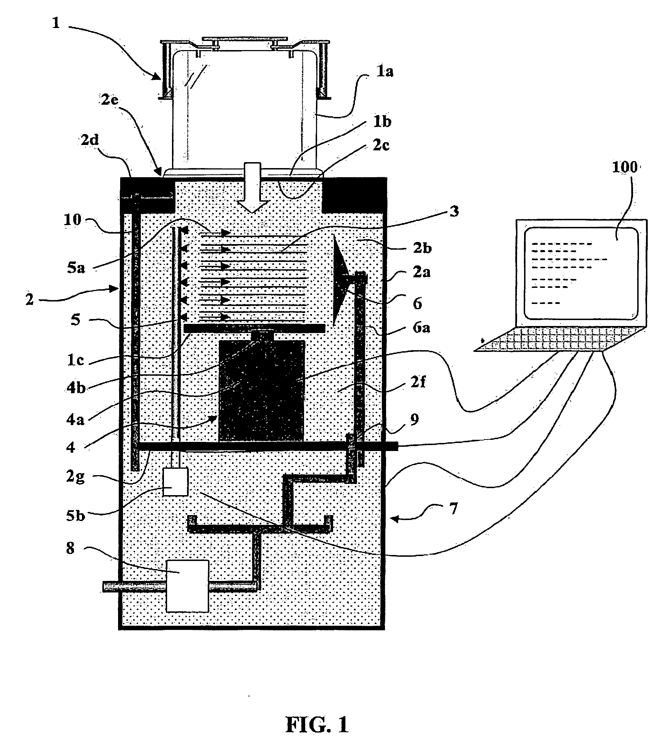

Dans le mode de réalisation illustré schématiquement sur la figure 1, le dispositif selon l'invention est adapté à la purge d'une enceinte de mini-environnement 1 de type SMIF, ayant une paroi périphérique étanche 1a et un passage d'accès inférieur 1b obturable par une paroi de base 1c.

Le dispositif comprend une station de purge 2, ayant une paroi périphérique 2a étanche pour délimiter un compartiment étanche de purge 2b, avec un passage de transfert 2c prévu sur la face supérieure 2d, le passage de transfert 2c étant également obturable par des moyens d'obturation non représentés sur la figure.

Des moyens d'accouplement étanches 2e sont prévus autour du passage d'accès 2c, pour l'accouplement étanche de l'enceinte de mini-environnement 1 autour du passage d'accès 2c, en permettant le déplacement vertical de la paroi de base 1c de l'enceinte de mini-environnement 1 jusqu'à l'intérieur du compartiment étanche de purge 2b.

Une pile de tranches de substrat disjointes 3 est disposée sur la paroi de base 1c de l'enceinte de mini-environnement 1, ladite paroi de base 1c ayant une dimension horizontale supérieure à la dimension des tranches de substrat de la pile 3.

Comme on le réalise habituellement, la pile de tranches de substrat 3 peut être une cassette par laquelle les substrats individuels sont tenus à l'écart les uns des autres selon un écartement prédéfini.

Des moyens de manipulateur 4 assurent le déplacement de la pile de tranches de substrat disjointes 3 et de la paroi de base 1c entre l'enceinte de mini-environnement 1 et le compartiment étanche de purge 2b. Dans le cas illustré sur la figure 1, les moyens de manipulateur 4 comprennent un ascenseur, illustré par un corps de vérin 4a et une tige de vérin 4b repoussant verticalement la paroi de base 1c vers et à l'écart du passage d'accès 2c. En position limite supérieure, la paroi de base 1c ferme l'enceinte de mini-environnement 1. En position limite inférieure telle qu'illustrée sur la figure 1, la paroi de base 1c et la pile de tranches de substrat 3 sont entièrement à l'intérieur du compartiment étanche de purge 2b, pour l'opération de purge.

Comme on le voit, le compartiment étanche de purge 2b a une dimension horizontale supérieure à la dimension horizontale des tranches de substrat à traiter, et a une dimension verticale nettement supérieure à la dimension verticale de la pile de tranches de substrat 3 à traiter. De préférence, en position limite inférieure illustrée sur la figure 1, le sommet de la pile de tranches de substrat 3 est situé nettement au-dessous du passage d'accès 2c, pour laisser largement ouvert le passage d'accès 2c afin de libérer le passage des gaz entre l'intérieur de l'enceinte de mini-environnement 1 et le compartiment étanche de purge 2b.

De préférence, le compartiment étanche de purge 2b comprend un volume de réserve inférieur 2f qui occupe un espace de hauteur satisfaisante au-dessous de la pile de tranches de substrat 3 pendant la purge.

Par exemple, le volume de réserve inférieur 2f présente une hauteur sensiblement égale à la hauteur de la pile de tranches de substrat 3, jusqu'à une paroi inférieure étanche 2g qui ferme la base du compartiment étanche de purge 2b.

On prévoit, dans le compartiment de purge 2b, des moyens de répartition 5, adaptés pour diffuser latéralement un gaz de purge en direction des chants des tranches de substrat parallèlement à leur face principale, comme illustré par exemple par la flèche 5a.

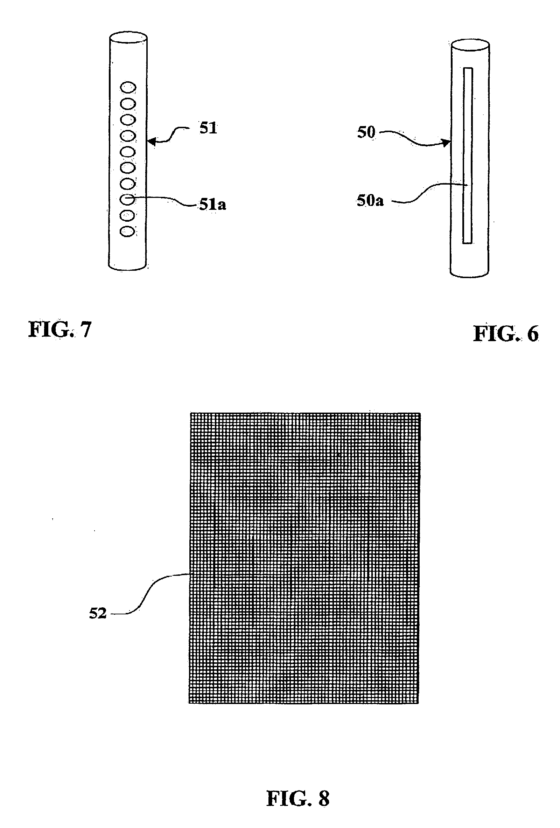

Par exemple, les moyens de répartition 5 peuvent comprendre une ou plusieurs colonnes de répartition 50, comme illustré sur la figure 6, comportant une fente 50a longitudinale continue, de largeur égale à 1 mm environ, orientée vers le centre de la pile des tranches de substrat 3 à traiter, pour le passage radial du gaz de purge.

Selon un autre exemple, les moyens de répartition 5 peuvent comprendre, comme illustré sur la figure 7, une ou plusieurs colonnes de répartition 51 ayant une série de trous 51a répartis le long d'une génératrice de la colonne de répartition 51 et orientés vers le centre de la pile de tranches de substrat 3.

Selon un autre exemple, les moyens de répartition 5 peuvent comprendre, comme illustré sur la figure 8, une grille verticale rectangulaire 52 placée latéralement en regard de la pile de tranches de substrat 3. La grille présente une taille de mailles appropriée pour une répartition régulière du flux de gaz de purge dans la direction de la pile de tranches de substrat 3. On peut par exemple utiliser des structures de filtre.

La hauteur des moyens de répartition 5 peut avantageusement être légèrement supérieure à la hauteur de la pile de tranches de substrat 3 à traiter. La structure des moyens de répartition 5 peut avantageusement être capable de créer un flux de gaz de purge selon toute la largeur de la pile de tranches de substrat 3.

En considérant à nouveau la figure 1 à l'opposé des moyens de répartition 5, on prévoit des moyens collecteurs 6 pour recueillir le flux diffusé de gaz de purge après passage entre les tranches de substrat de la pile de tranches de substrat 3.

Grâce aux moyens de répartition 5, le gaz de purge s'écoule régulièrement entre les tranches de substrat de la pile de tranches de substrat 3, et s'échappe par le collecteur 6 pour sortir du compartiment étanche de purge 2b.

Les moyens de répartition 5 sont connectés à une source de gaz de purge 5b. Le gaz de purge peut avantageusement être de l'azote.

Les moyens collecteurs 6 peuvent avantageusement être raccordés par une canalisation 6a à un dispositif de traitement de gaz de purge 7, adapté pour aspirer le gaz de purge recueilli par les moyens collecteurs 6.

Dans le dispositif de traitement de gaz de purge 7 illustré sur la figure 1, on prévoit notamment des moyens de pompage 8 pour pomper le gaz de purge, et des moyens de traitement non représentés sur la figure 1.

Les moyens de pompage 8 peuvent avantageusement être raccordés non seulement à la canalisation 6a des moyens collecteurs 6, mais également à un orifice inférieur 9 dans le volume de réserve inférieur 2f, et également au passage d'accès obturable 2c par l'intermédiaire d'une canalisation de dérivation 10.

La canalisation de dérivation 10 permet d'aspirer plus rapidement les gaz provenant de l'enceinte de mini-environnement 1 lors de l'ouverture par descente de la paroi de base 1c, limitant leur accumulation ultérieure dans le volume de réserve inférieur 2f. A cet égard, on remarquera que le gaz de purge tel que l'azote est légèrement plus léger que l'air à purger, et tend à monter dans l'enceinte de mini-environnement, tandis que l'air tend à descendre dans le compartiment étanche de purge 2b et finalement dans le volume de réserve inférieur 2f.

Un dispositif de commande 100 tel qu'un microordinateur ou un microcontrôleur permet de piloter les organes du dispositif tels que les moyens manipulateurs 4, le moyen de pompage 8, la source de gaz de purge 5b, de façon à réaliser la purge dans des conditions optimales.

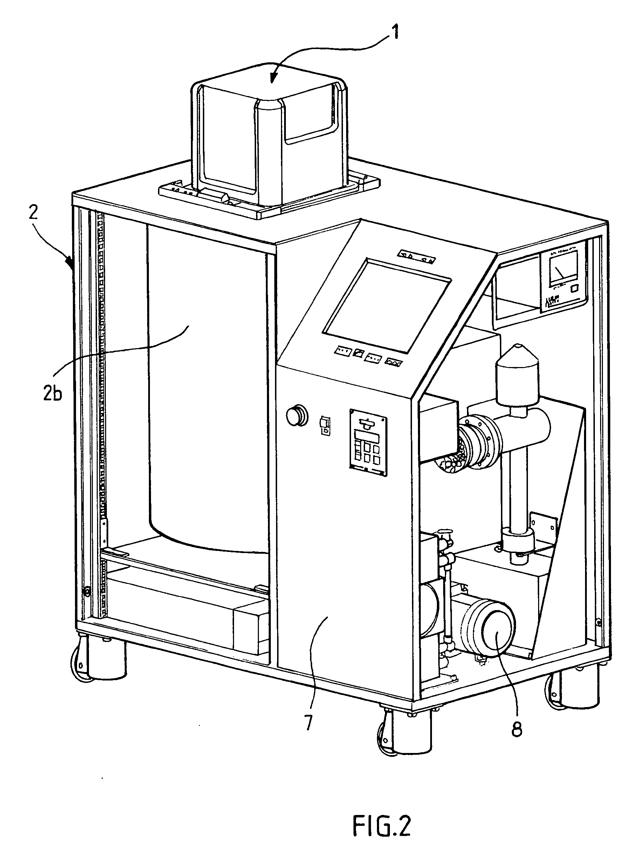

Sur la figure 2, on retrouve les éléments essentiels du dispositif, notamment l'enceinte de mini-environnement 1, la station de purge 2 avec le compartiment étanche de purge 2b, la station de traitement 7 avec la pompe à vide 8.

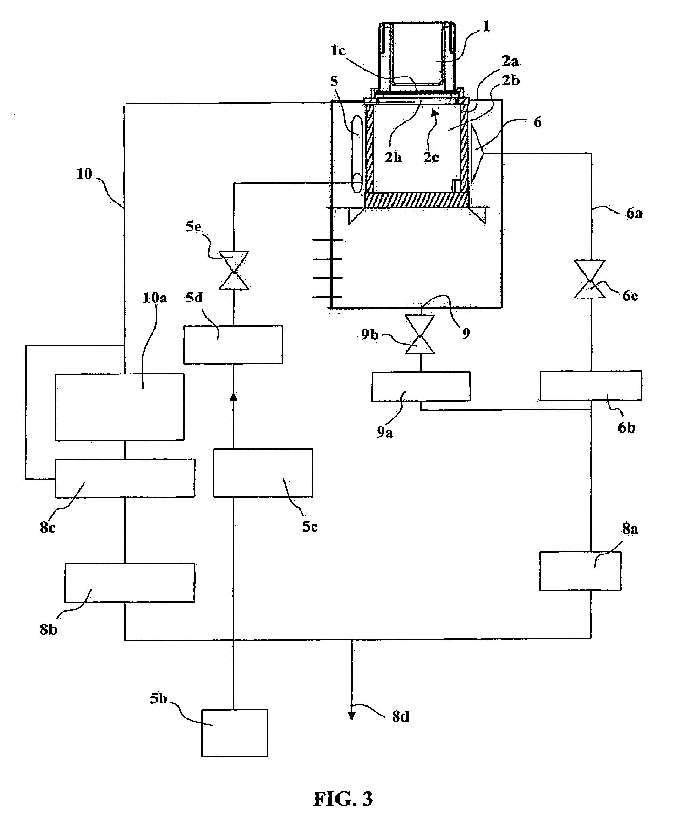

En se référant maintenant à la figure 3, on retrouve également les éléments essentiels comprenant la station de mini-environnement 1, le compartiment étanche de purge 2b isolé par la paroi périphérique 2a et avec un passage de transfert 2c obturé par le plateau 2h mobile qui vient en contact de la paroi de base 1c de l'enceinte de mini-environnement 1. Le plateau 2h est porté par le moyen manipulateur non représenté sur cette figure. On retrouve également les moyens de répartition 5 et les moyens collecteurs 6.

La source de gaz de purge 5b est connectée aux moyens de répartition 5 par l'intermédiaire d'un ensemble filtre-détendeur 5c suivi d'un régulateur de débit 5d et d'une vanne d'arrêt 5e. Les moyens collecteurs 6 sont reliés à une première pompe 8a par l'intermédiaire d'une restriction 6b en série dans la canalisation 6a et avec une vanne d'arrêt 6c. La même pompe 8a est raccordée à l'orifice inférieur 9 par l'intermédiaire d'une seconde restriction 9a et d'une vanne d'arrêt 9b.

Une seconde pompe 8b, connectée en série avec une pompe secondaire 8c, est raccordée par un capillaire constituant la canalisation de dérivation 10 à une prise de gaz au niveau du passage de transfert 2c, en partie supérieure du compartiment étanche de purge 2b.

En série dans la canalisation de dérivation 10, on peut avantageusement prévoir un analyseur de gaz 10a pour l'analyse des gaz pompés.

Les pompes 8a et 8b refoulent par une canalisation d'évacuation 8d.

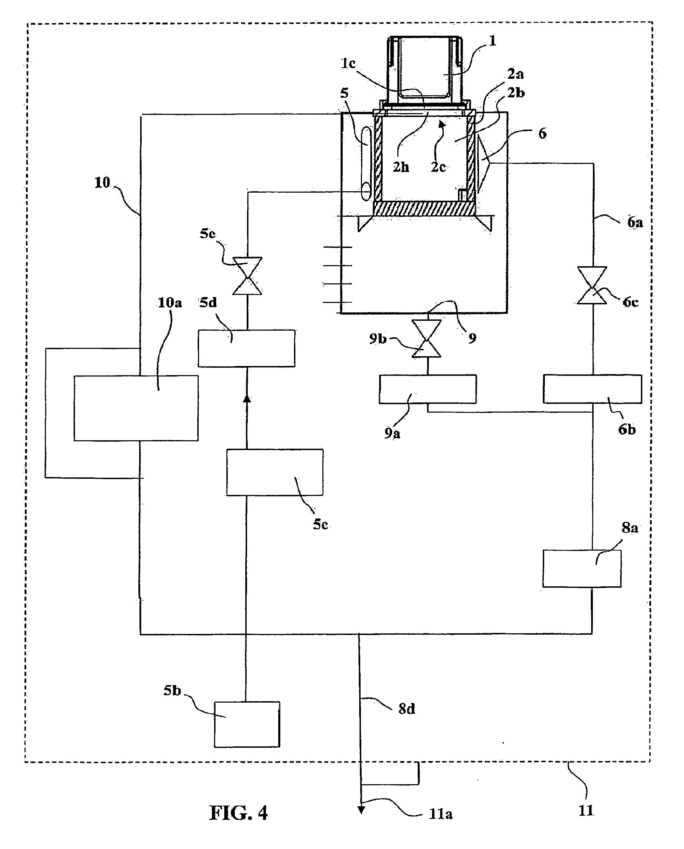

Dans un second mode de réalisation plus avantageux, illustré sur la figure 4, on utilise l'aspiration générale de la salle blanche pour évacuer les gaz de purge.

Dans ce mode de réalisation, le dispositif selon l'invention est placé dans la salle blanche, généralement illustrée par le rectangle en pointillés désigné par la référence 11. De façon connue en soi, la salle blanche 11 comporte une canalisation d'aspiration 11a elle-même connectée aux moyens de traitement d'air de la salle blanche.

On retrouve, dans ce mode de réalisation de la figure 4, les éléments essentiels du dispositif du mode de réalisation de la figure 3, et ces éléments sont repérés par les mêmes références numériques. En particulier, la structure de la station de purge 2 est identique, ainsi que les moyens 5, 5b, 5c, 5d et 5e pour injecter et distribuer un gaz de purge, et les moyens 6, 6a, 6b, 6c, 9, 9a et 8a pour recueillir et évacuer les gaz de purge.

La canalisation d'évacuation 8d est alors raccordée à la canalisation d'aspiration 11a de la salle blanche 11.

Et il n'est plus nécessaire de prévoir des moyens de pompage 8b et 8c en série avec les moyens d'analyse de gaz pompé 10a, l'aspiration assurée par la canalisation d'aspiration 11a étant suffisante.

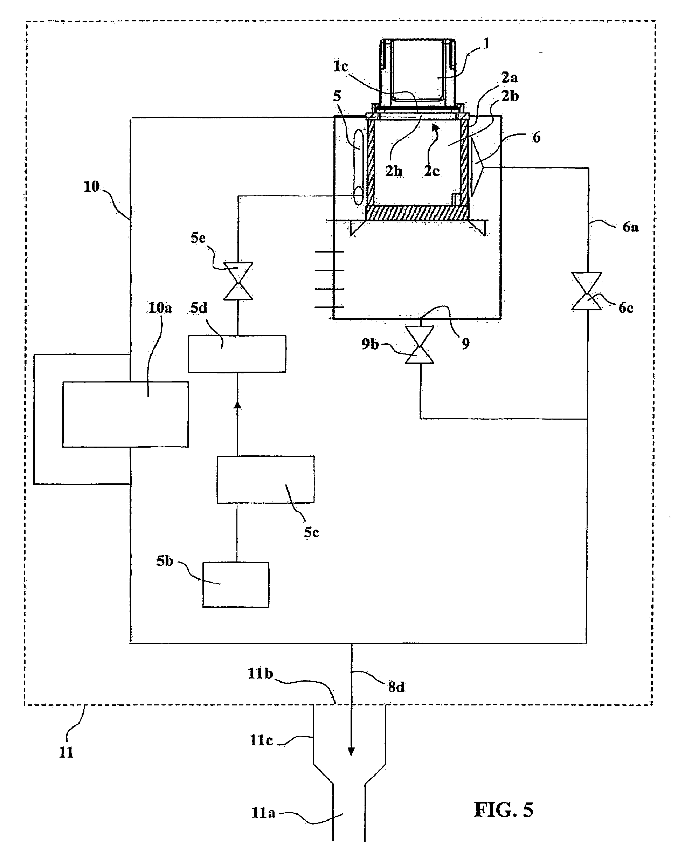

Dans un mode de réalisation préféré illustré sur la figure 5, on utilise à nouveau l'aspiration générale de la salle blanche pour recueillir les gaz de purge et assurer la purge. On retrouve, dans ce mode de réalisation de la figure 5, les éléments essentiels du mode de réalisation de la figure 4, et ces éléments essentiels sont repérés par les mêmes références numériques.

C'est ainsi que l'on retrouve la même structure de station de purge 2, les mêmes moyens 5, 5b, 5c, 5d et 5e pour la diffusion du gaz de purge, les mêmes moyens 6, 6a, 6c, 9 et 9b pour recueillir les gaz de purge, les mêmes moyens d'analyse de gaz 10a, avec une canalisation d'évacuation 8d.

Une première différence réside dans le mode de connexion de la canalisation 8d avec la canalisation d'aspiration 11a de la salle blanche 11 : dans ce cas, la canalisation d'évacuation 8d se déverse de façon non étanche à l'entrée 11b d'un collecteur de sortie 11c, ladite entrée 11b étant elle-même largement ouverte sur la salle blanche 11, et la sortie du collecteur de sortie 11c étant connectée à la canalisation d'aspiration 11a de la salle blanche 11. De la sorte, les deux canalisations 8d et 11a ne sont pas connectées de façon étanche entre elles, ce qui permet au volume de purge de ne jamais être en dépression et de rester à une pression voisine de la pression atmosphérique. L'absence de dépression permet d'éviter toute dégradation de la paroi de l'enceinte de mini-environnement 1. La disposition envisagée sur la figure 5 permet également de purger l'enceinte de mini-environnement elle-même.

Une seconde différence réside dans le fait qu'aucune pompe n'est plus nécessaire, ni dans la canalisation 6a, ni dans la canalisation 10, comme on le voit sur la figure 5.

Lors de l'utilisation, on peut avantageusement procéder de la manière expliquée ci-après.

Le compartiment étanche de purge 2b est préalablement rempli d'azote, avant l'accouplement et l'ouverture de l'enceinte de mini-environnement 1 et avant la descente de la pile de tranches de substrat 3, dans le but de favoriser la purge.

L'enceinte de mini-environnement est posée sur la station de purge 2, et se trouve connectée à la station de purge par sa paroi inférieure. Le moyen de manipulateur 4 descend la paroi de base 1c, ouvrant ainsi l'espace intérieur de l'enceinte de mini-environnement 1 pour sa communication avec le compartiment étanche de purge 2b. Poursuivant sa course, le moyen manipulateur 4 descend la pile de tranches de substrat 3 pour l'introduire entièrement dans le compartiment étanche de purge 2b. Simultanément, on introduit de l'azote par la colonne de répartition 5, et on aspire l'azote par le moyen collecteur 6.

Lors de la descente de la pile de tranches de substrat 3, le gaz tel que l'air contenu initialement dans le mini-environnement 1 et descendant par le passage de transfert 2c est peu dilué. Il est alors avantageux de procéder à ce moment là à l'analyse des gaz, par un analyseur de gaz 10a tel qu'un spectromètre à mobilité ionique (IMS), ou encore par un capteur de concentration de gaz à onde acoustique de surface (SAW) sur un matériau piézo-électrique.

On contrôle ainsi l'atmosphère à l'intérieur de l'enceinte de mini-environnement 1 et on peut enregistrer son évolution par le moyen de commande 100. On peut ainsi conserver l'évolution historique de la qualité de l'atmosphère dans l'enceinte de mini-environnement 1.

On peut également moduler la fréquence et la durée des injections d'azote.

La purge de la pile de tranches de substrat 3 nécessite une durée comprise entre 1 et 5 minutes, suivant le débit d'injection du gaz de purge, et le niveau de purge escompté. Ensuite, la pile de tranches de substrat 3 est remontée dans l'enceinte de mini-environnement 1. Dès lors, l'enceinte de mini-environnement 1 peut être enlevée de la station de purge 2. L'injection de gaz de purge dans la station de purge 2 est poursuivie encore pendant une durée de 5 à 10 minutes pour la vider de l'air résiduel avant l'adaptation d'une autre enceinte de mini-environnement 1.

Le dispositif de commande 100 réalise la vitesse de purge la plus appropriée et la plus efficace, pour assurer une purge efficace sans provoquer une contamination additionnelle qui pourrait résulter d'un flux trop important et des frictions qui en résulteraient sur la surface des substrats à traiter.

Une vitesse trop élevée peut être détectée par les moyens d'analyse de gaz 10a en sortie dans le dispositif de traitement des gaz de purge 7.

Le dispositif selon l'invention permet de réaliser une purge beaucoup plus efficace et rapide que les dispositifs de l'art antérieur, et favorise ainsi l'utilisation des enceintes de mini-environnement telles que les enceintes SMIF dans les procédés de microélectronique.

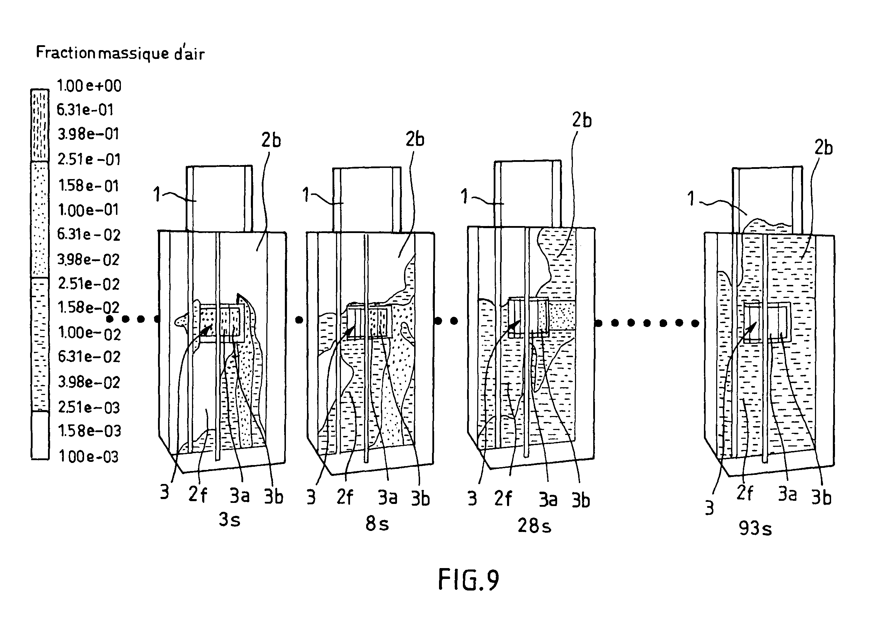

La figure 9 illustre l'évolution de la concentration résiduelle d'air lors d'une purge par l'azote dans une station de purge selon l'invention. La figure a été réalisée par simulation, et représente l'enceinte de mini-environnement 1 associée à un compartiment étanche de purge 2b contenant la pile de tranches de substrat 3. L'échelle de dégradés de gris indique la concentration d'air des différentes zones. Les quatre dessins illustrent, de gauche à droite, l'évolution de la purge après 3 secondes, 8 secondes, 28 secondes, 93 secondes. Un courant d'azote pur est diffusé dans la pile de tranches de substrat 3 de la gauche vers la droite, et est extrait vers la droite.

Après 3 secondes, l'air quasiment pur occupe encore les zones de droite 3a et d'extrême droite 3b, et un écoulement de mélange riche en air se produit vers le bas depuis l'extrémité droite de la pile de tranches de substrat 3.

Après 8 secondes, l'air quasiment pur n'occupe plus que la zone d'extrême droite 3b.

Après 28 secondes, la concentration d'air dans la zone d'extrême droite 3b est de l'ordre de 5e-02, tandis qu'elle est inférieure à 1e-02 dans le reste de la pile de tranches de substrat 3. Une concentration d'air d'environ 5e-02 à 1e-01 persiste également dans la portion droite du volume de réserve inférieur 2f.

Après 93 secondes, la concentration d'air est inférieure à 1e-02 dans tout le volume de la pile de tranches de substrat 3. De l'air résiduel en concentration de l'ordre de 5e-02 persiste seulement dans le volume de réserve inférieur 2f, et l'on voit que la présence du volume de réserve inférieur 2f réduit sensiblement la concentration résiduelle d'air dans la zone supérieure de compartiment étanche de purge 2b contenant la pile de tranches de substrat 3.

La présente invention n'est pas limitée aux modes de réalisation qui ont été explicitement décrits, mais elle en inclut les diverses variantes et généralisations qui sont à la portée de l'homme du métier.

## Revendications

1. Dispositif pour le contrôle et la réduction de la contamination d'une pile de tranches de substrat (3) disjointes placée dans une enceinte de mini-environnement (1), comprenant ladite enceinte de mini-environnement (1) ayant une paroi périphérique étanche (1a) munie d'un passage d'accès obturable (1b) pour l'introduction et le retrait de la pile de tranches de substrats (3), **caractérisé en ce que** ledit dispositif comprend en outre une station de purge (2) en combinaison avec ladite enceinte, ladite station de purge comportant :
- un compartiment étanche de purge (2b) dimensionné pour recevoir et contenir la pile de tranches de substrat disjointes (3),
- un passage de transfert obturable (2c) et des moyens (2e) pour l'accouplement sélectif étanche du passage d'accès obturable (1b) de l'enceinte de mini-environnement (1) sur le passage de transfert obturable (2c),
- des moyens de manipulateur (4) pour le déplacement de la pile de tranches de substrat (3) entre l'enceinte de mini-environnement (1) et le compartiment étanche de purge (2b),
- des moyens diffuseurs (5) adaptés pour diffuser latéralement un gaz de purge en direction des chants des tranches de substrat de la pile de tranches de substrat (3) parallèlement à leur face principale,
- des moyens collecteurs (6), disposés pour recueillir le flux diffusé de gaz de purge à l'opposé des moyens diffuseurs (5) après passage entre les tranches de substrat de la pile de tranches de substrat (3).

2. Dispositif selon la revendication 1, **caractérisé en ce que** les moyens diffuseurs (5) comprennent une ou plusieurs colonnes de répartition ayant une fente longitudinale continue de largeur appropriée pour le passage radial du gaz de purge.

3. Dispositif selon la revendication 1, **caractérisé en ce que** les moyens diffuseurs (5) comprennent une ou plusieurs colonnes de répartition ayant une série de trous répartis le long d'une génératrice de la colonne de répartition.

4. Dispositif selon la revendication 1, **caractérisé en ce que** les moyens diffuseurs (5) comportent une grille verticale rectangulaire (52) placée latéralement en regard de la pile de tranches de substrat (3).

5. Dispositif selon l'une quelconque des revendications 1 à 4, **caractérisé en ce que** le compartiment étanche de purge (2b) comprend un volume de réserve inférieur (2f) occupant l'espace au-dessous de la pile de tranches de substrat disjointes (3) pendant la purge.

6. Dispositif selon l'une quelconque des revendications 1 à 5, **caractérisé en ce que** l'enceinte de mini-environnement (1) est une enceinte à interface mécanique standardisée (SMIF), dont la paroi de base (1c) ferme le passage d'accès obturable (1b) et est déplaçable verticalement en supportant la pile de tranches de substrat disjointes (3),
- la station de purge (2) comporte une face supérieure (2d) munie du passage de transfert obturable (2c) et munie des moyens d'accouplement étanches (2e) pour l'accouplement autour du passage d'accès (2c) en autorisant le déplacement vertical de la paroi de base (1c) d'enceinte de mini-environnement (1) et de la pile de tranches de substrat disjointes (3) jusqu'à l'intérieur du compartiment étanche de purge (2b),
- les moyens de manipulateur (4) comprennent un ascenseur logé dans le compartiment étanche de purge (2b) et adapté pour supporter la paroi de base (1c) de l'enceinte de mini-environnement (1) et la pile de tranches de substrat (3) disjointes pour les déplacer entre l'enceinte de mini-environnement (1) et le compartiment étanche de purge (2b).

7. Dispositif selon la revendication 6, **caractérisé en ce que** la station de purge (2) comprend en outre un dispositif de traitement de gaz de purge (7), connecté à l'espace intérieur du compartiment étanche de purge (2b) pour recueillir les gaz de purge.

8. Dispositif selon la revendication 7, **caractérisé en ce que** le dispositif de traitement de gaz de purge (7) est connecté :
- au dispositif collecteur (6), pour recevoir les gaz de purge après leur passage entre les tranches de substrat de la pile de tranches de substrat disjointes (3),
- au volume de réserve inférieur (2f), pour recevoir les gaz confinés dans le volume de réserve inférieur (2f),
- à la zone supérieure du compartiment étanche de purge (2b), au voisinage du passage de transfert obturable (2c).

9. Dispositif selon l'une des revendications 7 ou 8, **caractérisé en ce qu'**il comprend des moyens de pompage (8) pour aspirer les gaz de purge hors du compartiment étanche de purge (2b) et les refouler dans une canalisation d'évacuation (8d).

10. Dispositif selon l'une quelconque des revendications 7' à 9, **caractérisé en ce que** la canalisation d'évacuation (8d) est raccordée à la canalisation d'aspiration (11a) de la salle blanche (11).

11. Dispositif selon l'une quelconque des revendications 7 à 9, **caractérisé en ce que** la canalisation d'évacuation (8d) se déverse de façon non étanche à l'entrée (11b) d'un collecteur de sortie (11c), ladite entrée (11b) étant elle-même largement ouverte sur la salle blanche (11) et la sortie du collecteur de sortie (11c) étant connectée à la canalisation d'aspiration (11a) de la salle blanche (11).

12. Dispositif selon l'une quelconque des revendications 7 à 11, **caractérisé en ce qu'**il comprend des moyens d'analyse des gaz pompés (10a).

13. Dispositif selon la revendication 12, **caractérisé en ce que** les moyens d'analyse des gaz pompés (10a) comprennent un spectromètre à mobilité ionique (IMS).
